(19) Europäisches Patentamt / European Patent Office / Office européen des brevets

(11) **EP 4 183 848 A1**

(12) **EUROPEAN PATENT APPLICATION**

(43) Date of publication:
**24.05.2023 Bulletin 2023/21**

(21) Application number: **22207886.7**

(22) Date of filing: **16.11.2022**

(51) International Patent Classification (IPC):
**C09J 7/30** $^{(2018.01)}$       **B32B 7/12** $^{(2006.01)}$
**H01L 21/683** $^{(2006.01)}$

(52) Cooperative Patent Classification (CPC):
**C09J 7/30; B32B 7/12; B32B 27/08; B32B 27/308;
H01L 21/6836;** B32B 2264/102; B32B 2264/1051;
B32B 2264/1055; B32B 2405/00; B32B 2457/14;
C08K 2003/0806; C08K 2003/085;
C08K 2003/2248; C08K 2003/2286;
C09J 2203/326;                           (Cont.)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.11.2021 JP 2021189336**

(71) Applicant: **NITTO DENKO CORPORATION
Ibaraki-shi
Osaka 567-8680 (JP)**

(72) Inventors:
• **MITA, Ryota
Osaka, 567-8680 (JP)**
• **SATO, Mayu
Osaka, 567-8680 (JP)**

(74) Representative: **Stolmár & Partner
Patentanwälte PartG mbB
Blumenstraße 17
80331 München (DE)**

(54) **DICING DIE BONDING FILM**

(57)     Provided is a dicing die bonding film including a dicing tape including a base layer, an adhesive layer laminated on the base layer, and a die bonding sheet laminated on the adhesive layer of the dicing tape, in which the die bonding sheet includes conductive metal particles, the die bonding sheet and the adhesive layer each include a polar group-containing compound, the polar group-containing compound is a compound having at least one of one or more hydroxy groups or a plurality of ether bonds in a molecule, and a peel force between the die bonding sheet and the adhesive layer is more than 0.05 N/50 mm.

Fig. 1

EP 4 183 848 A1

**(Cont. next page)**

(52) Cooperative Patent Classification (CPC): (Cont.)
C09J 2301/312; C09J 2301/41; C09J 2433/00;
C09J 2433/006; C09J 2463/006;
H01L 2221/68327; H01L 2221/68336;
H01L 2221/68377

**Description**

FIELD OF THE INVENTION

The present invention relates to a dicing die bonding film used in, for example, producing a semiconductor device.

BACKGROUND OF THE INVENTION

A dicing die bonding film used in production of a semiconductor device is conventionally known. The dicing die bonding film of this type includes, for example, a dicing tape, and a die bonding sheet laminated on the dicing tape and configured to be bonded to a wafer. The dicing tape includes a base layer and an adhesive layer in contact with the die bonding sheet. The dicing die bonding film of this type is used in production of the semiconductor device, for example, in the manner as described below.

In general, a method for producing a semiconductor device includes a pre-step of forming a circuit surface on one side of a wafer with a highly integrated circuit, and a post-step of cutting a chip from the wafer with the circuit surface formed thereon and assembling the semiconductor device. When a semiconductor device including a power semiconductor element used with a relatively large power, the following steps can be performed in the post-step.

The post-step includes, for example: a mounting step of attaching, to an adhesive layer of the die bonding sheet laminated on the dicing tape, the opposite surface to the circuit surface of the wafer (i.e., semiconductor wafer) that has the circuit surface formed thereon, to fix the wafer thereon; a dicing step of cutting both of the semiconductor wafer and the die bonding sheet into small pieces by, for example, a dicing saw; an expanding step of expanding a gap between the semiconductor wafer chips cut into small pieces; a pick-up step of releasing the die bonding sheet attached to the adhesive layer of the dicing tape and cut into small pieces; a die bonding step of bonding the chip (i.e., die) with the die bonding sheet attached thereto to an adherend via the die bonding sheet; and a curing step of subjecting the die bonding sheet bonded to the adherend to a thermosetting treatment. The semiconductor device including a power semiconductor element is produced by way of, for example, these steps.

As the dicing die bonding film used in the method for producing the aforementioned semiconductor device, known is a dicing die bonding film having, for example, a die bonding sheet including a thermosetting resin, a volatile component, and conductive particles (for example, Patent Literature 1).

Specifically, in the dicing die bonding film described in Patent Literature 1, a weight loss ratio W1 is 0.5 mass% or less when the die bonding sheet is heated from room temperature to 100 °C with heat conditions at 10 °C/min in a nitrogen gas flow at 200 mL/min and maintained at 100 °C for 30 min, and a weight loss ratio W2 is 2 mass% or more when the die bonding sheet is heated from 100 °C to 200 °C with heat conditions at 10 °C/min in the nitrogen gas flow at 200 mL/min and maintained at 200 °C for 30 min. The die bonding sheet of the dicing die bonding film described in Patent Literature 1 enables a relatively high heat dissipation performance after the thermosetting treatment.

CITATION LIST

Patent Literature

Patent Literature 1: JP 2021-077765 A

SUMMARY

Technical Problem

The die bonding sheet cut into pieces is sometimes unintentionally peeled from the adhesive layer due to the force generated by cutting the semiconductor wafer into small pieces using a dicing blade or the like in, for example, the aforementioned dicing step. Such a phenomenon is also known as a chip-flying phenomenon. There is a tendency that the chip-flying phenomenon easily occur as the storage time of the unused dicing die bonding film is longer. It is assumed that this tendency is caused because the peel force between the adhesive layer of the dicing tape and the die bonding sheet is reduced with time. In order to prevent the occurrence of the chip-flying phenomenon, it is conceivable to design the dicing die bonding film so as to suppress the reduction of the peel force between the adhesive layer of the dicing tape and the die bonding sheet with time and have a relatively high peel force after the lapse of the time even if the peel force is reduced with time.

Nevertheless, no sufficient consideration appears to have been made on the dicing die bonding film configured to suppress the reduction of the peel force between the adhesive layer of the dicing tape and the die bonding sheet with time and have a relatively high peel force after the lapse of the time.

It is therefore an object of the present invention to provide a dicing die bonding film configured to suppress the reduction of the peel force between the adhesive layer of the dicing tape and the die bonding sheet with time and have a relatively high peel force after the lapse of the time.

Solution to Problem

In order to solve the aforementioned problem, the dicing die bonding film according to the present invention includes a dicing tape including a base layer, an adhesive layer laminated on the base layer, and a die bonding sheet laminated on the adhesive layer of the dicing tape, in which the die bonding sheet includes conductive metal particles, the die bonding sheet and the adhesive layer each include a polar group-containing compound, the polar group-containing compound is a compound having at least one of one or more hydroxy groups or a plurality of ether bonds in a molecule, and a peel force between the die bonding sheet and the adhesive layer is more than 0.05 N/50 mm.

BRIEF DESCRIPTION OF DRAWINGS

Fig. 1 is a schematic cross-sectional view of a dicing die bonding film of an embodiment which is cut in a thickness direction.
Fig. 2 is a cross-sectional view schematically showing a state of a mounting step in a method for producing a semiconductor device.
Fig. 3 is a cross-sectional view schematically showing a state of a dicing step in the method for producing the semiconductor device.
Fig. 4 is a cross-sectional view schematically showing a state of an expanding step in the method for producing the semiconductor device.
Fig. 5 is a cross-sectional view schematically showing a state of a pick-up step in the method for producing the semiconductor device.
Fig. 6 is a cross-sectional view schematically showing a state of a die bonding step in the method for producing the semiconductor device.
Fig. 7 is a graph showing a change with time in a peel force between a die bonding sheet and an adhesive layer.
Fig. 8 is a graph showing a change with time in a peel force between a die bonding sheet and an adhesive layer expressed with a relative value.

DETAILED DESCRIPTION OF THE PREFERRED EMBODIMENT

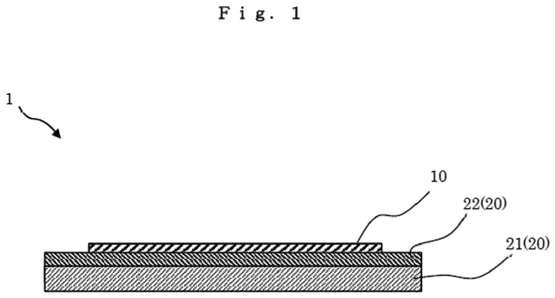

Hereinafter, a description will be given on one embodiment of the dicing die bonding film according to the present invention.
The dicing die bonding film 1 of this embodiment includes a die bonding sheet 10 and a dicing tape 20 attached to the die bonding sheet 10.
As shown in Fig. 1, the dicing die bonding film 1 of this embodiment includes a dicing tape 20, and a die bonding sheet 10 laminated on an adhesive layer 22 of the dicing tape 20 to be bonded to a semiconductor wafer. In production of a semiconductor device, the die bonding sheet 10 is bonded to an adherend such as a circuit board or a semiconductor chip.
Note that the figures in the drawings are schematic illustrations and each do not necessarily have the same aspect ratio as that of the actual product.

<Die bonding sheet of a dicing die bonding film>

In this embodiment, the die bonding sheet 10 includes at least conductive metal particles and a polar group-containing compound. Also, the die bonding sheet 10 includes a thermosetting resin. The die bonding sheet 10 can include an epoxy resin as the thermosetting resin. Further, the die bonding sheet 10 can include an acrylic resin.
The thickness of the die bonding sheet 10 can be 1 $\mu$m or more, can be 10 $\mu$m or more, or can be 20 $\mu$m or more. The thickness of the die bonding sheet 10 can be 150 $\mu$m or less, can be 100 $\mu$m or less, or 80 $\mu$m or less. The smaller the thickness of the die bonding sheet 10, the better the thermal conductivity of the die bonding sheet 10. Note that, when the die bonding sheet 10 is a laminate body, the aforementioned thickness is a total thickness of the laminate body.
The die bonding sheet 10 can have a single layer structure as shown in, for example, Fig. 1. The single layer herein means a layer or layers formed by the same component. Thus, a form in which a plurality of layers formed by the same component are laminated together is also referred to as the single layer. On the other hand, the die bonding sheet 10 can have a multilayer structure in which, for example, layers formed by two or more different components respectively are laminated together. When the die bonding sheet 10 has the multilayer structure, the die bonding sheet 10 can have layers as long as it includes at least one layer that includes at least the conductive metal particles and the polar group-containing compound.

The die bonding sheet 10 preferably includes 85 mass% or more and 97 mass% or less of the conductive metal particles. Thereby, the die bonding sheet 10 can have high thermal conductivity.

The conductive metal particles contain at least a metal element. The shape of the conductive metal particles is not particularly limited, and can be, for example, a spherical shape, a plate shape, and a needle shape. The shape of the conductive metal particles is preferably a spherical shape. The shape of the conductive metal particles being a spherical shape allows the conductive metal particles to be filled in the die bonding sheet 10 at a higher density.

Examples of the conductive metal particles include particles formed by at least either one of a metal or a metal oxide, or composite particles including metal and a material other than the metal. The particles formed by at least either one of a metal or a metal oxide can be any particles as long as the particles contain a metal element and, for example, can be metal particles having a surface at least partly covered with a metal oxide. The particles formed only by a metal can be formed by different metals or formed by a single metal. Examples of the particles formed by different metals include particles having a core part of nickel particles, copper particles, silver particles, aluminum particles, or the like, and a surface layer part covering at least part of the surface of the core part. Examples of the material adopted for the surface layer part include gold and silver. Examples of the composite particles include particles having a core part of resin particles or the like, and a surface layer part covering at least part of the surface of the core part with metal such as nickel, gold, or the like. The core part can be formed by a carbon material such as carbon black or carbon nanotube. As the composite particles, for example, those having metal particles subjected to a surface treatment with a fatty acid can be adopted.

The content of the composite particles to the total mass of the conductive metal particles is preferably 60 mass% or more and 98 mass% or less.

These conductive metal particles can be individually used, or two or more different particles can be adopted in combination.

The conductive metal particles preferably include at least one selected from the group consisting of silver, copper, silver oxide, and copper oxide. The conductive metal particles can be, for example, particles including at least one of silver and copper as the metal. Alternatively, the conductive metal particles can be in a state where a surface of particles that include at least one of silver and copper as the metal is at least partly covered with at least one of silver oxide and copper oxide. Specifically, the conductive metal particles can be in a state where a surface of silver particles is at least partly covered with silver oxide, or in a state where a surface of copper particles is at least partly covered with copper oxide.

The conductive metal particles are preferably sinterable metal particles sintered by a sintering treatment. The sinterable metal particles each have a surface layer part at least partly formed by a metal and are firmly adhered to each other when the sinterable metal particles are heated at a temperature equal to or lower than the melting point of the metal. The conductive metal particles that are sinterable metal particles can allow at least part of the sinterable metal particles to be sintered by subjecting the die bonding sheet 10 to the thermosetting treatment. Therefore, heat transfer paths are more easily formed inside the die bonding sheet 10. In particular, a heat transfer path in the thickness direction is likely to be formed. This enables a relatively high heat dissipation performance of the die bonding sheet 10. As the sinterable metal particles, particles, in which at least a surface layer part is formed by at least any one of gold, silver, and copper, are preferable.

The average particle size of the conductive metal particles can be 1 nm or more and 10 $\mu$m or less. The aforementioned average particle size can be 10 nm or more. The larger the average particle size of the conductive metal particles is, the more the cohesion of the particles to each other can be suppressed. This has an advantage that the conductive metal particles are more easily dispersed in the die bonding sheet 10. In general, the price of the conductive metal particles tends to be lower as the average particle size is larger. The aforementioned average particle size can be 5 $\mu$m or less. The smaller the average particle size of the conductive metal particles, the larger number of the heat transfer paths described above can be formed.

The average particle size of the conductive metal particles adopted herein means a smaller value among the average particle sizes respectively measured by the following first and second methods. In the case where it is difficult to perform the measurement by the first method, the measurement is performed by the second method. In the first method, the average particle size of the conductive metal particles is measured, using, for example, a laser diffraction and scattering type particle size measuring apparatus (Microtrac MT3000II series manufactured by MicrotracBEL). A median diameter D50 obtained from the cumulative curve when the total volume of powder of the conductive metal particles is 100% (volume distribution) is designated as the average particle size. On the other hand, in the second method, the average particle size of the conductive metal particles can be measured from the observation image of the sinterable metal particles observed by a scanning electron microscope (SEM). For example, the average particle size of the conductive metal particles is obtained by averaging the diameters of at least 100 particles selected at random in the observation images observed at a magnification of 5,000 times to 300,000 times.

In this embodiment, the die bonding sheet 10 can include 0.1 mass% or more of the polar group-containing compound, or can include 0.5 mass% or more thereof. The die bonding sheet 10 can include 10.0 mass% or less of the polar group-containing compound, can include 5.0 mass% or less thereof, or can include 3.0 mass% or less thereof. Since the die bonding sheet 10 includes the polar group-containing compound, a tackiness is imparted to the die bonding sheet 10. Accordingly, the die bonding sheet 10 has a good tight adhesiveness to the semiconductor wafer. Therefore, the die bonding sheet 10 can be suitably handled in production of the semiconductor device. The polar group-containing compound is included in the adhesive layer 22 of the dicing tape 20 and is compatible with the components included in the dicing tape 20.

In the die bonding sheet 10, a ratio B (mass%) of the polar group-containing compound to the total mass (without including the conductive metal particles) of a resin component such as a thermosetting resin and an acrylic resin (to be described later) and the polar group-containing compound can be 10 mass% or more, or can be 15 mass% or more. The ratio B (mass%) can be 30 mass% or less, or can be 25 mass% or less. The resin component herein means all of polymer compounds included in the die bonding sheet 10. For example, a component (e.g., silane coupling agent) mixed to bind the resin component to the conductive metal particles, and a catalyst to proceed the curing reaction are excluded from the resin component.

The polar group-containing compound is a compound having at least one of one or more hydroxy groups or a plurality of ether bonds in a molecule. Since the polar group-containing compound is included in each of both the die bonding sheet 10 and the adhesive layer 22 laminated with each other, the transfer of the polar group-containing compound from the die bonding sheet 10 to the adhesive layer 22 is suppressed. In other words, the polar group-containing compound included in the adhesive layer 22 suppresses the polar group-containing compound included in die bonding sheet 10 from transferring from the die bonding sheet 10 to the adhesive layer 22. Since the aforementioned transfer occurs with time, the amount of the polar group-containing compound remaining at the interface between the die bonding sheet 10 and the adhesive layer 22 increases with time. Accordingly, the peel force between the die bonding sheet 10 and the adhesive layer 22 can be reduced with time by the polar group-containing compound at the interface. In contrast, according to this embodiment, the amount of the polar group-containing compound at the interface can be reduced by suppressing the transfer of the polar group-containing compound. Accordingly, it is possible to suppress the reduction with time of the peel force between the die bonding sheet 10 and the adhesive layer 22.

On the other hand, in the case where the polar group-containing compound is not included in the adhesive layer 22, the polar group-containing compound is easily transferred from the die bonding sheet 10 to the adhesive layer 22, which thus causes a relatively large amount of the polar group-containing compound at the interface. Thereby, it is assumed that the peel force between the die bonding sheet 10 and the adhesive layer 22 is reduced with time. Such a phenomenon has been demonstrated in Examples to be described later.

The boiling point of the polar group-containing compound is preferably 200 °C or more, more preferably 250 °C or more. The aforementioned boiling point can be 350 °C or less. The boiling point of the polar group-containing compound at 250 °C or more enables the polar group-containing compound to be further suppressed from volatilization from the die bonding sheet 10. Therefore, the physical characteristics of the polar group-containing compound can be more easily exhibited inside the die bonding sheet 10. Also, the boiling point of the polar group-containing compound at 350 °C or less enables the polar group-containing compound to be more easily volatilized from the die bonding sheet 1 when the die bonding sheet 1 is subjected to the thermosetting treatment. Accordingly, the polar group-containing compound can become more easily volatilized when the die bonding sheet 10 is subjected to the thermosetting treatment in the curing step. Thereby, the conductive metal particles described above come into closer contact with each other so that the heat transfer paths can be more easily formed.

It is preferable that a vapor pressure at 25 °C of the polar group-containing compound be 1 mmHG or less and a glass transition point of the polar group-containing compound be 250 °C or less.

With the vapor pressure at 25 °C of the polar group-containing compound being 1 mmHg or less, the polar group-containing compound is hardly volatilized from the die bonding sheet 10 at room temperature, and thus, the polar group-containing compound remains inside the die bonding sheet 10 until the die bonding sheet 10 is subjected to the thermosetting treatment. Therefore, the desired physical characteristics (e.g., a viscosity) of the polar group-containing compound can be exhibited in the die bonding sheet 10 before the die bonding sheet 10 is subjected to the thermosetting treatment. The vapor pressure is measured by a gas flow method.

The viscosity of the polar group-containing compound at 25 °C is preferably 0.1 (Pa ·s) or more and 100,000 (Pa ·s) or less. The aforementioned viscosity is a value measured by a rheometer using a parallel plate (gap: 200 $\mu$m, shear rate: 1 (1/s)).

The compound including at least one hydroxy group in a molecule has, for example, in the molecule, a hydrocarbon part and at least one hydroxy group bonded to the hydrocarbon part. The hydrocarbon part can be a saturated hydrocarbon, or can be an unsaturated hydrocarbon. The hydrocarbon part can be a straight-chain hydrocarbon or branched chain hydrocarbon, or can be a cyclic hydrocarbon. The polar group-containing compound preferably includes the cyclic hydrocarbon in the molecule, more preferably includes the saturated cyclic hydrocarbon in the molecule.

The polar group-containing compound preferably includes, in the molecule, a plurality of saturated cyclic hydrocarbons and one hydroxy group bonded to any one of carbons of one saturated cyclic hydrocarbon out of the plurality of saturated cyclic hydrocarbons. The polar group-containing compound more preferably has a molecule structure in which one carbon in a C6 saturated cyclic hydrocarbon is covalently bonded to one carbon in a C7 saturated cyclic hydrocarbon having two saturated cyclic hydrocarbons sharing two carbons, and includes one hydroxy group in the molecule. Still more preferably in the polar group-containing compound, the hydroxy group is bonded to any one of carbons in the C6 saturated cyclic hydrocarbon in this molecule structure. The molecule weight of the polar group-containing compound can be, for example, 150 or more and 300 or less.

It is most preferable that the polar group-containing compound be isobornyl cyclohexanol.

Isobornyl cyclohexanol is also referred to as 4-[1,7,7-trimethylbicyclo[2.2.1] heptane-2-yl]cyclohexanol. The boiling point of isobornyl cyclohexanol is within a range of 308 °C or more and 318 °C or less. The vapor pressure of isobornyl cyclohexanol at 25 °C is 0.00003 mmHg. Isobornyl cyclohexanol has specific physical characteristics as follows. Specifically, when isobornyl cyclohexanol is heated from room temperature (23 $\pm$ 2 °C) to 600 °C with heat conditions at 10 °C/min in the nitrogen gas flow at 200 mL/min, and isobornyl cyclohexanol is rapidly volatilized after the temperature reaches 100 °C or more, and almost all of it is volatilized at 245 °C. In addition, the viscosity of isobornyl cyclohexanol at 60 °C is as relatively low as 1,000 mPa -s, while the viscosity thereof at 25 °C is as extremely high as 1,000,000 mPa ·s.

As described above, isobornyl cyclohexanol has an extremely high viscosity at 25 °C so that the die bonding sheet 10 including isobornyl cyclohexanol can more sufficiently maintain the sheet shape at room temperature. On the other hand, isobornyl cyclohexanol having a relatively low viscosity at about 60 °C as described above can have a tackiness. That is, the die bonding sheet 10 including isobornyl cyclohexanol can maintain the sheet shape at room temperature and have a tackiness at about 60 °C.

For example, in the mounting step to be described later, a semiconductor chip is attached (temporarily bonded) to an adherend such as a metal lead frame via the die bonding sheet 10, while being heated at a temperature of 60 °C or more and 80 °C or less. Since isobornyl cyclohexanol has a tackiness at about 60 °C as described above, the die bonding sheet 10 including isobornyl cyclohexanol can be properly attached to the adherend. In other words, it is possible to suppress the temporarily bonded die bonding sheet 10 from being lifted up from the adherend and the positional displacement from the position at which the semiconductor chip is attached. Therefore, isobornyl cyclohexanol is included in the die bonding sheet 10 so that the semiconductor chip can be temporarily bonded to the adherend with a relatively high reliability.

The compound including a plurality of ether bonds in the molecule, which is the polar group-containing compound, has, for example, a molecule structure in which hydrocarbon and ether bond are alternately repeated. Examples of the compound having such a molecule structure include a glyme compound.

The glyme compound is a straight-chain glycol diether compound. The glyme compound can be represented by, for example, a molecule structural formula: $R-O(CH_2CH_2O)_n-R'$. In this molecule structural formula, R and R' each are an alkyl group individually, and n is an integer number equal to or greater than 1. Examples of the alkyl group include a methyl group, an ethyl group, a propyl group, an isopropyl group, and a butyl group. The methyl group is preferable as the alkyl group of R and R'. It is preferable that n be an integer number from 1 to 4.

Examples of the glyme compound include monoglyme, diglyme, triglyme, tetraglyme, pentaglyme, and poly(ethylene glycol)dimethyl ether (i.e., PEGDME, polyglyme). The glyme compound with the total carbon number of 4 or more and 14 or less is preferable as the glyme compound.

In this embodiment, the die bonding sheet 10 includes a thermosetting resin.

Examples of the thermosetting resin include an epoxy resin, a phenol resin, an amino resin, an unsaturated polyester resin, a polyurethane resin, a silicone resin, and a thermosetting polyimide resin. These thermosetting resins can be individually adopted, or two or more different resins can be adopted in combination.

Examples of the epoxy resin include the epoxy resin of bisphenol A type, bisphenol F type, bisphenol S type, brominated bisphenol A type, hydrogenated bisphenol A type, bisphenol AF type, biphenyl type, naphthalene type, fluorene type, phenol novolak type, cresol novolak type, trishydroxyphenylmethane type, tetraphenylolethane type, hydantoin type, trisglycidyl isocyanurate type, or glycidyl amine type. The bisphenol A type epoxy resin or the cresol novolak type epoxy resin is preferable as the epoxy resin.

The epoxy resin can be, at room temperature, in a liquid form or in a solid form.

The phenol resin can function as a curing agent for the epoxy resin. Examples of the phenol resin include a novolak type phenol resin, a resol type phenol resin, and polyoxystyrene such as polyparaoxystyrene. Examples of the novolak type phenol resin include a phenol novolak resin, a phenol aralkyl resin (e.g., a biphenyl aralkyl type phenol resin), a cresol novolak resin, tert-butyl phenol novolak resin, a nonyl phenol novolak resin, and a phenol xylylene resin. The hydroxyl equivalent (g/eq) of the phenol resin can be, for example, 90 or more and 220 or less. The biphenyl aralkyl type phenol resin having a relatively high hydroxyl equivalent is preferable in terms of enabling the die bonding sheet 10 to have a moderately low elastic modulus. These phenol resins can be individually adopted, or two or more different resins can be adopted in combination.

The die bonding sheet 10 preferably includes at least the epoxy resin as the thermosetting resin. The inclusion of the epoxy resin in the die bonding sheet 10 enables the die bonding sheet 10 to have a better adhesive strength after it is cured.

The acrylic resin that can be included in the die bonding sheet 10 is a polymer compound in which at least a (meth)acrylic acid ester monomer is polymerized. The inclusion of the acrylic resin in the die bonding sheet 10 enables the die bonding sheet 10 to have a moderate flexibility. Also, the elastic modulus of the die bonding sheet 10 can be relatively easily adjusted by changing the type of monomer when the acrylic resin is polymerized. In this description, the term "(meth)acrylic acid" means at least one of a methacrylic acid and an acrylic acid, and the term "(meth)acrylate" means at least one of a methacrylate (methacrylic acid ester) and acrylate (acrylic acid ester). Same applies to the term "(meth)acryl".

The acrylic resin can be a crosslinkable acrylic resin having a crosslinkable group in the molecule. The crosslinkable acrylic resin preferably includes a crosslinkable group in the side chain. The crosslinkable acrylic resin can have the crosslinkable group at a terminal of the side chain. The crosslinkable acrylic resin can have the crosslinkable group at at least one of both terminals of the main chain.

The crosslinkable group in the molecule of the crosslinkable acrylic resin is not particularly limited as long as it is a functional group that causes a crosslinking reaction by the thermosetting treatment. Examples of the crosslinkable group include a crosslinkable group having an active hydrogen.

Examples of the crosslinkable group having the active hydrogen include a hydroxy group and a carboxy group. These crosslinkable groups can cause a crosslinking reaction with an epoxy group or an isocyanate group. For example, the crosslinkable acrylic resin having at least one of the hydroxy group and the carboxy group in the molecule can cause the crosslinking reaction with the compound having the epoxy group or the isocyanate group in the molecule (e.g., the epoxy resin described above).

A content ratio of structural units of a crosslinkable group-containing monomer in the crosslinkable acrylic resin can be 0.5 mass% or more and 50.0 mass% or less, or can be 1 mass% or more and 40 mass% or less. The aforementioned content ratio being 0.5 mass% or more enables more sufficient progress of the crosslinking reaction when the die bonding sheet 10 is subjected to the thermosetting treatment. On the other hand, the aforementioned content ratio being 50.0 mass% or less can further suppress bending or warping of the die bonding sheet 10, which is accompanied with the thermosetting treatment, by setting the die bonding sheet 10 having been subjected to the thermosetting treatment at a lower elastic modulus. The structural unit herein means a structure derived from each of monomers after polymerization of the monomers (e.g., 2-ethylhexyl acrylate, hydroxyethyl acrylate) to obtain the crosslinkable acrylic resin. Same applies to the following description.

The crosslinkable acrylic resin can be synthesized, for example, by a general polymerization method using a radical polymerization initiator. Alternatively, a commercially available product can be used as the crosslinkable acrylic resin.

The crosslinkable acrylic resin preferably includes a largest amount of the structural units of an alkyl (meth)acrylate monomer among the structural units in the molecule in terms of the mass ratio. Examples of the alkyl (meth)acrylate monomer include a C2-C18 alkyl (meth)acrylate monomer in which the carbon number of the alkyl group (i.e., hydrocarbon group) is 2 or more and 18 or less.

Examples of the alkyl (meth)acrylate monomer include a saturated straight-chain alkyl (meth)acrylate monomer, a saturated branched chain alkyl (meth)acrylate monomer, and a saturated cyclic alkyl (meth)acrylate monomer.

Examples of the saturated straight-chain alkyl (meth)acrylate monomer include ethyl (meth)acrylate, n-propyl (meth)acrylate, n-butyl (meth)acrylate, n-heptyl (meth)acrylate, n-octyl (meth)acrylate, n-nonyl (meth)acrylate, n-decyl (meth)acrylate, tridecyl (meth)acrylate, lauryl (meth)acrylate, myristyl (meth)acrylate, palmityl (meth)acrylate, and stearyl (meth)acrylate. The carbon number of a straight-chain alkyl group part is preferably 2 or more and 18 or less. Examples of the saturated branched chain alkyl (meth)acrylate monomer include isoheptyl (meth)acrylate, isooctyl (meth)acrylate, isononyl (meth)acrylate, isodecyl (meth)acrylate, and 2-ethylhexyl (meth)acrylate. An alkyl part can have any one of an iso-structure, a sec-structure, a neo-structure, or a tert-structure.

The crosslinkable acrylic resin has structural units derived from the crosslinkable group-containing monomer that can be copolymerized with the alkyl (meth)acrylate monomer. In this embodiment, the crosslinkable acrylic resin is an acrylic resin obtained by copolymerization of at least the alkyl (meth)acrylate monomer and the crosslinkable group-containing monomer. In other words, the crosslinkable acrylic resin has a structure in which the structural units of the alkyl (meth)acrylate monomer and the structural units of the crosslinkable group-containing monomer are connected in random order.

Examples of the crosslinkable group-containing monomer include a functional group-containing monomer such as a carboxy group-containing (meth)acrylic monomer, a hydroxy group-containing (meth)acrylic monomer, a sulfonate group-containing (meth)acrylic monomer, and a phosphate group-containing (meth)acrylic monomer. The crosslinkable group-containing monomer can have an ether group, an ester group, or the like in the molecule.

The crosslinkable acrylic resin is preferably a copolymer of the crosslinkable group-containing monomer, which is at least one selected from the carboxy group-containing (meth)acrylic monomer and the hydroxy group-containing (meth)acrylic monomer, with the alkyl (meth)acrylate monomer (in particular, alkyl (meth)acrylate in which the carbon number of the alkyl part is 1 or more and 4 or less).

Examples of the carboxy group-containing (meth)acrylic monomer include a (meth)acrylic acid monomer, and a mono(2-(meth) acryloyloxyethyl) succinate monomer. The carboxy group can be located at a terminal position of the monomer structure, or can be bonded to a hydrocarbon located at a position other than the terminal position. Examples of the hydroxy group-containing (meth)acrylic monomer include a hydroxyethyl (meth)acrylate monomer, a hydroxypropyl (meth)acrylate monomer, and a hydroxybutyl (meth)acrylate monomer. The hydroxy group can be located at a terminal position of the monomer structure, or can be bonded to a hydrocarbon located at a position other than the terminal position.

When the die bonding sheet 10 includes the thermosetting resin such as the epoxy resin or the phenol resin, the mass ratio of the thermosetting resin to the total amount of the thermosetting resin and the acrylic resin such as the crosslinkable acrylic resin (i.e., amount of resin components excluding the conductive metal particles, the silane coupling agent, and the catalyst) in the die bonding sheet 10 is preferably 80 mass% or less, more preferably 75 mass% or less, still more preferably 45 mass% or less. Thereby, the die bonding sheet 10 after the thermosetting treatment can have a lower elastic modulus. Therefore, bending or warping of the die bonding sheet 10 accompanied with the thermosetting treatment can be further suppressed. The aforementioned mass ratio can be 20 mass% or more.

The die bonding sheet 10 can include a component other than the thermosetting resin and the crosslinkable acrylic resin. For example, the die bonding sheet 10 can further include a thermosetting resin other than the crosslinkable acrylic resin.

Examples of the thermosetting resin other than the crosslinkable acrylic resin, which can be included in the die bonding sheet 10, include a natural rubber, a butyl rubber, an isoprene rubber, a chloroprene rubber, an ethylene-vinyl acetate copolymer, an ethylene- acrylic acid copolymer, an ethylene-acrylic acid ester copolymer, a polybutadiene resin, a polycarbonate resin, a thermoplastic polyimide resin, a polyamide resin such as 6-polyamide resin or 6,6-polyamide resin, a phenoxy resin, an acrylic resin without including the crosslinkable functional group in the molecule, a saturated polyester resin such as PET or PBT, a polyamide-imide resin, and a fluororesin. These thermoplastic resins can be individually used, or two or more different resins can be adopted in combination.

The mass ratio of the crosslinkable acrylic resin to the total amount of the thermosetting resin and the acrylic resin such as the crosslinkable acrylic resin included in the die bonding sheet 10 (i.e., amount of resin components excluding the conductive metal particles, the silane coupling agent, and the catalyst) is preferably 20 mass% or more and 50 mass% or less.

In the die bonding sheet 10, the amount of the aforementioned resin components (i.e., total amount of, for example, the crosslinkable acrylic resin and the thermosetting resin described above) based on 100 parts by mass of the conductive metal particles can be 1 part by mass or more and 30 parts by mass or less, or can be 10 parts by mass or less.

The die bonding sheet 10 can further include, for example, a curing catalyst, a flame retarder, a silane coupling agent, an ion trapping agent, or a colorant.

Next, the dicing tape 20 attached to the die bonding sheet 10 will be described in detail.

The adhesive layer 22 of the dicing tape 20 is cured by irradiation of an active energy ray (e.g., ultraviolet ray) before or during the use of the dicing die bonding film 1 of this embodiment. For example, at least the adhesive layer 22 is irradiated with an ultraviolet ray or the like, for example, before the die bonding sheet 10 and the adhesive layer 22 are laminated together. Irradiation of an ultraviolet ray or the like causes the adhesive layer 22 to be cured to thereby reduce the adhesive force of the adhesive layer 22 to a moderate level. Thereby, the die bonding sheet 10 (in a state where the semiconductor wafer is bonded thereto) can be relatively easily peeled from the adhesive layer 22 in a pick-up step to be described later.

<Dicing tape of a dicing die bonding film>

In general, the dicing tape 20 is an elongated sheet and is stored in a wound state until it is used. The dicing die bonding film 1 of this embodiment is spread and mounted on an annular frame having an inner diameter one size larger than a silicon wafer, and is subjected to a cut and break treatment when in use.

The dicing tape 20 includes a base layer 21 and the adhesive layer 22 laminated on the base layer 21.

(Base layer of dicing tape)

The base layer 21 can have a single layer structure, or can have a layered structure (e.g., triple layer structure).

The thickness (i.e., the total thickness) of the base layer 21 can be 80 μm or more and 150 μm or less.

Each layer of the base layer 21 is, for example, a metal foil, a fiber sheet such as paper or fabric, a rubber sheet, or a resin film. Examples of the fiber sheet that forms the base layer 21 include paper, woven fabric, and unwoven fabric. Examples of the material of the resin film include: polyolefin such as polyethylene (PE), polypropylene (PP), or an ethylene-propylene copolymer; an ethylene copolymer such as an ethylene-vinyl acetate copolymer (EVA), an ionomer resin, an ethylene-(meth)acrylic acid copolymer, or an ethylene-(meth)acrylic acid ester (random or alternating) copolymer; polyester such as polyethylene terephthalate (PET), polyethylene naphthalene (PEN), or polybutylene terephthalate (PBT); polyacrylate; polyvinyl chloride (PVC); polyurethane; polycarbonate; polyphenylene sulfide (PPS); polyamide such as aliphatic polyamide or wholly aromatic polyamide (aramid); polyether ether ketone (PEEK); polyimide; polyether imide; polyvinylidene chloride; acrylonitrile butadiene styrene copolymer (ABS); cellulose or cellulose derivative; a silicone-containing polymer; and a fluorine-containing polymer. These materials can be individually used, or two or more different materials can be used in combination.

The base layer 21 is preferably formed by a polymer material such as a resin film. When the base layer 21 includes the resin film, the resin film can be subjected to, for example, a stretch treatment, to thereby control the deformability such as a stretch rate. A surface of the base layer 21 can be subjected to a surface treatment in order to increase its adhesiveness to the adhesive layer 22. Examples of the surface treatment that can be herein adopted include a chemical treatment such as chromic acid treatment, ozone exposure, flame exposure, high-pressure electric shock exposure, or ionized radiation treatment; or a physical treatment such as oxidation treatment. Further, a coating treatment using a coating agent such as an anchor coating agent, a primer, and an adhesive agent can be subjected to the surface of the base layer 21.

A back surface side (i.e., a side on which the adhesive layer 22 is not laminated) of the base layer 21 can be subjected to a release treatment using a releasing agent (i.e., remover) such as a silicone-based resin or a fluorine-based resin in order to impart peelability. The base layer 21 is preferably, for example, a light-transmissive (ultraviolet-transmissive) resin film because an active energy ray such as an ultraviolet ray can be applied to the adhesive layer 22 from the back surface side thereof.

(Adhesive layer of dicing tape)

In this embodiment, the adhesive layer 22 includes, for example, an acrylic polymer having at least structural units of alkyl (meth)acrylate in a molecule, an isocyanate compound, and a polymerization initiator.

The adhesive layer 22 can have a thickness of 5 μm or more and 40 μm or less. In general, the shape and size of the adhesive layer 22 are the same as the shape and size of the base layer 21.

In this embodiment, the peel force between the die bonding sheet 10 and the adhesive layer 22 of the dicing tape 20 is more than 0.05 (N/50 nm). Even if the peel force is reduced with time, the peel force more than 0.05 (N/50 nm) enables the peel force after it is reduced with time to be maintained at a relatively high level. The peel force can be less than 0.30 (N/50 nm), or can be less than 0.25 (N/50 nm).

The aforementioned peel force is measured after the adhesive layer 22 is sufficiently cured by being subjected to a curing treatment and before the die bonding sheet 10 is subjected to the curing treatment.

The peel force can be, for example, an initial peel force immediately after the dicing die bonding film 1 is produced (i.e., within one day after the production).

The peel force is measured by the following measurement method. A rectangular test piece with a size of 150 mm × 50 mm is cut from a portion in which the die bonding sheet 10 and the adhesive layer 22 are laminated with each other. Using a hand roller, a backing tape (product name "BT315" manufactured by NITTO DENKO CORPORATION) is attached to the die bonding sheet 10 at room temperature. Thereafter, a peel strength is measured when the die bonding sheet 10 is peeled from the adhesive layer 22 by a Tensilon type tensile tester (AGSJ manufactured by Shimadzu Corporation). As the measuring apparatus, for example, the product name "AUTOGRAPH AGS-J" (manufactured by Shimadzu Corporation) can be used. The peeling conditions are set as follows: under the environment at 23 °C, at a peeling angle of 180°, and at a peeling speed of 300 mm/min.

The peel force can be increased by, for example, increasing the polarity of a later-described acrylic polymer included in the adhesive layer 22. On the other hand, the peel force can be reduced by, for example, decreasing the polarity of the acrylic polymer (to be described later). The polarity of the acrylic polymer can be adjusted by changing the ratio of a polar monomer (e.g., hydroxyl group-containing (meth)acrylate monomer) in a copolymer composition when the acrylic polymer is polymerized.

When the peel force is X and the peel force after the lapse of 7 days from the measurement of the peel force X is Y, it is preferable that Y/X be more than 0.5 and less than 1.5. The value of Y/X more than 0.5 enables the peel force after the lapse of time to be further increased. The value of Y/X can be less than 1.0.

The peel force Y after the lapse of time can be increased by, for example, reducing the amount of the polar group-containing compound to be mixed in the adhesive layer 22 of the dicing tape 20. On the other hand, the peel force after the lapse of time can be reduced by, for example, increasing the amount of the polar group-containing compound to be mixed in the adhesive layer 22 of the dicing tape 20.

In this embodiment, both of the die bonding sheet 10 and the adhesive layer 22 include the polar group-containing compounds respectively. Therefore, it is possible to suppress the transfer of the polar group-containing compound from the die bonding sheet 10 to the adhesive layer 22 with time, compared with the case where only the die bonding sheet 10 includes the polar group-containing compound. Thereby, it is possible to suppress the polar group-containing compound from increasing with time at the interface between the die bonding sheet 10 and the adhesive layer 22. It is conceivable that the peel force can be suppressed from being reduced with time because of the polar group-containing compound that is not increased at the interface. The polar group-containing compounds included respectively in the die bonding sheet 10 and the adhesive layer 22 can be the same compound or can be two or more different compounds as long as the compounds can be embraced by the definition of the aforementioned polar group-containing compound.

In this embodiment, a formula of $0.1 \leq A/B \leq 3.0$ can be satisfied, when a ratio of the polar group-containing compound in a mass of the adhesive layer 22 is A (mass%) and a ratio of the polar group-containing compound in the total mass of a resin component and the polar group-containing compound included in the die bonding sheet 10 is B (mass%). The value of A/B within the above numerical range enables to further suppress the reduction of the peel force with time between the die bonding sheet 10 and the adhesive layer 22 of the dicing tape 20, and enables to further increase the peel force after the lapse of time. The value can be $0.5 \leq A/B$. Also, the value can be $A/B. \leq 2.0$.

The adhesive layer 22 can include 1.0 mass% or more of the polar group-containing compound, or can include 5.0 mass% or more thereof. The adhesive layer 22 can include 40.0 mass% or less of the polar group-containing compound, or can include 40.0 mass% or less thereof, or can include 30.0 mass% or less thereof, or can include 20.0 mass% or less thereof.

In this embodiment, the acrylic polymer included in the adhesive layer 22 has, in the molecule, at least structural units of alkyl (meth)acrylate, structural units of hydroxy group-containing (meth)acrylate, and structural units of polymerizable group-containing (meth)acrylate. The structural unit is a unit that constitutes the main chain of the acrylic polymer. Each side chain in the acrylic polymer is included in each structural unit that constitutes the main chain of the acrylic polymer.

In the acrylic polymer included in the adhesive layer 22, the structural units can be confirmed by, for example, an NMR analysis such as $^1$H-NMR and $^{13}$C-NMR, a thermal decomposition GC/MS analysis, and an infrared spectroscopy. In general, the molar ratio of each of the structural units of the acrylic polymer can be calculated from the blending amount (i.e., input amount) when the acrylic polymer is polymerized.

The structural units of the aforementioned alkyl (meth)acrylate are derived from an alkyl (meth)acrylate monomer. In other words, a molecular structure of the alkyl (meth)acrylate monomer after the polymerizing reaction is the structural unit of alkyl (meth)acrylate. The expression "alkyl" herein means a hydrocarbon part that is bonded to (meth)acrylic acid by an ester bond. The hydrocarbon part of the alkyl part in the structural unit of alkyl (meth)acrylate can be a saturated hydrocarbon, or can be an unsaturated hydrocarbon. The carbon number of the hydrocarbon part can be 6 or more, or can be 8 or more. The carbon number of the hydrocarbon part can be 10 or less.

In the structural units of the acrylic polymer, it is preferable that the ratio of the structural units of alkyl (meth)acrylate in which the carbon number of the alkyl part is 8 or more be highest in the molecule on molar basis, and it is more preferable that the ratio of the structural units of alkyl (meth)acrylate in which the carbon number of the branched chain alkyl part is 8 or more be highest in the molecule on molar basis. It is conceivable that this configuration makes it possible to more sufficiently suppress a so-called chip-flying phenomenon (to be described later in detail), while keeping the pick-up performance (i.e., performance to relatively easily peel the die bonding sheet 10 and the semiconductor chip from the adhesive layer 22) in the pick-up step to be described later. The chip-flying phenomenon is a phenomenon that, when the semiconductor wafer and the die bonding sheet 10 are cut into small pieces, the die bonding sheet 10 and the semiconductor chip cut into small pieces are undesirably peeled from the adhesive layer 22. In other words, the peeling of the die bonding sheet 10 from the adhesive layer 22 when the peel force is applied along any direction of a plane direction can be further suppressed because the ratio of the structural units of alkyl (meth)acrylate in which the carbon number of the alkyl part is 8 or more is highest, based on molar basis, among the structural units of the acryl polymer included in the adhesive layer. On the other hand, the die bonding sheet 10 can be relatively easily peeled from the adhesive layer 22 when the peel force is applied along a vertical direction to the plane direction.

Examples of the structural unit of alkyl (meth)acrylate include a structural unit of each of hexyl (meth)acrylate, 2-ethylhexyl (meth)acrylate, n-nonyl (meth)acrylate or iso-nonyl (meth)acrylate, and decyl (meth)acrylate.

The acrylic polymer included in the adhesive layer 22 preferably further includes structural units of (meth)acrylate having a heterocycle (hetero ring) structure in the molecule. The cohesion properties of the acrylic polymer can be further improved by including a polarized part such as nitrogen (N) or oxygen (O) in the molecule of the acrylic polymer. Accordingly, the peel force between the die bonding sheet 10 and the adhesive layer 22 including the acrylic polymer can be further improved. Also, it is possible to further suppress a phenomenon (i.e., adhesive residue) that, when the adhesive layer 22 is peeled from the die bonding sheet 10, part of the adhesive layer 22 is separated and adhered to a peeled surface of the die bonding sheet 10. As the heterocycle (hetero ring) structure, a structure having at least one of nitrogen (N) and oxygen (O) is preferable. Examples of the structural unit of (meth)acrylate having the heterocycle (hetero ring) structure in the molecule include (meth)acryloylmorpholine.

In this embodiment, the acrylic polymer has the structural units of hydroxy group-containing (meth)acrylate, and the hydroxy group of each of the aforementioned structural units easily reacts with an isocyanate group. The adhesive layer 22 can be appropriately cured by allowing the isocyanate compound and the acrylic polymer having the structural units of hydroxy group-containing (meth)acrylate to coexist in the adhesive layer 22. Therefore, the acrylic polymer can be sufficiently gelled. Thus, the adhesive layer 22 can exhibit the adhesion performance, while maintaining its shape.

It is preferable that the structural unit of hydroxy group-containing (meth)acrylate be a structural unit of hydroxy group-containing C2-C4 alkyl (meth)acrylate. The expression "C2-C4 alkyl" herein means a hydrocarbon part bonded to (meth)acrylic acid by an ester bond and a carbon number of the hydrocarbon part. In other words, a hydroxy group-containing C2-C4 alkyl (meth)acrylate monomer means a monomer in which (meth)acrylic acid and a C2-C4 alcohol (generally, divalent alcohol) are bonded by an ester bond. In general, the hydrocarbon part of C2-C4 alkyl is a saturated hydrocarbon. For example, the hydrocarbon part of C2-C4 alkyl is a straight-chain saturated hydrocarbon or branched-chain saturated hydrocarbon. It is preferable that the hydrocarbon part of C2-C4 alkyl do not have a polar group that contains oxygen (O), nitrogen (N), or the like.

Examples of the structural unit of the hydroxy group-containing C2-C4 alkyl (meth)acrylate include each of the structural units of hydroxy ethyl (meth)acrylate, hydroxypropyl (meth)acrylate, or hydroxybutyl (meth)acrylate such as hydroxy n-butyl (meth)acrylate or hydroxy iso-butyl (meth)acrylate. In the structural unit of hydroxybutyl (meth)acrylate, the hydroxy group (-OH group) can be bonded to carbon (C) at the terminal of the hydrocarbon part, or can be bonded to carbon (C) other than at the terminal of the hydrocarbon part.

In this embodiment, the acrylic polymer has a structural unit of polymerizable group-containing (meth)acrylate having a polymerizable unsaturated double bond at the side chain. The adhesive layer 22 can be cured by irradiation of the active energy ray (e.g., ultraviolet ray) due to the inclusion of the structural unit of polymerizable group-containing (meth)acrylate in the acrylic polymer. Specifically, it is possible to generate a radical from a photopolymerization initiator by irradiation of the active energy ray such as ultraviolet ray, to thereby cause the crosslinking reaction of the acrylic polymers with each other by the action of the radical. Thereby, the adhesive force of the adhesive layer 22 before irradiation can be reduced by the irradiation. Then, the die bonding sheet 10 can be favorably peeled from the adhesive layer 22. As the active energy ray, ultraviolet ray, radioactive ray, or electron beam can be adopted.

The structural unit of polymerizable group-containing (meth)acrylate can have a molecular structure, specifically, in which an isocyanate group of an isocyanate group-containing (meth)acrylic monomer is bonded to the hydroxy group in the aforementioned structural unit of the hydroxy group-containing (meth)acrylate by an urethane bond.

The structural unit of polymerizable group-containing (meth)acrylate having a polymerizable group can be prepared after a polymerization treatment. For example, the aforementioned structural unit of polymerizable group-containing (meth)acrylate can be obtained by, for example, copolymerization of the alkyl (meth)acrylate monomer with the hydroxy group-containing (meth)acrylic monomer, followed by urethanization reaction of the hydroxy group in part of the structural unit of the hydroxy group-containing (meth)acrylate with the isocyanate group of the isocyanate group-containing polymerizable monomer.

The isocyanate group-containing (meth)acrylic monomer preferably has one isocyanate group and one (meth)acryloyl group in the molecule. Examples of such a monomer include 2-methacryloyloxyethyl isocyanate.

The adhesive layer 22 of the dicing tape 20 in this embodiment further includes an isocyanate compound. The isocyanate compound can be present with part thereof having been reacted by, for example, the urethanization reaction. The isocyanate compound has a plurality of isocyanate groups in the molecule. The plurality of isocyanate groups in the molecule in the isocyanate compound enables the crosslinking reaction between acrylic polymers in the adhesive layer 22 to proceed further. Specifically, the crosslinking reaction via the isocyanate compound can be made to proceed further by causing one of the isocyanate groups in the isocyanate compound to be reacted with the hydroxy group of the acrylic polymer, while causing the other of the isocyanate groups in the isocyanate compound to be reacted with another hydroxy group of the acrylic polymer.

Examples of the isocyanate compound include diisocyanate such as aliphatic diisocyanate, alicyclic diisocyanate, and aromatic aliphatic diisocyanate.

Also, examples of the isocyanate compound include polymerized polyisocyanate such as a dimer or trimer of diisocyanate, and polymethylene polyphenylene polyisocyanate.

In addition, examples of the isocyanate compound include polyisocyanate obtained by causing an excess amount of the aforementioned isocyanate compound to be reacted with an active hydrogen-containing compound. Examples of the active hydrogen-containing compound include an active hydrogen-containing low-molecular weight compound, and an active hydrogen-containing high-molecular weight compound. For example, allophanated polyisocyanate and biuret-formed polyisocyanate can be used as the isocyanate compound. These isocyanate compounds can be individually used, or two or more isocyanate compounds can be used in combination.

It is preferable that the isocyanate compound be a reactant of aromatic diisocyanate with the active hydrogen-containing low-molecular weight compound. Since the reaction rate of the isocyanate group in the reactant of the aromatic diisocyanate is relatively low, the adhesive layer 22 including the reactant can be suppressed from being cured excessively. The isocyanate compound having 3 or more isocyanate compounds in the molecule is preferable as the isocyanate compound.

The polymerization initiator included in the adhesive layer 22 is a compound that can initiate the polymerization reaction by application of heat energy or light energy. The inclusion of the polymerization initiator in the adhesive layer 22 enables the crosslinking reaction between the acrylic polymers to be progressed when the heat energy or the light energy is applied to the adhesive layer 22. Specifically, the polymerization initiator can initiate the polymerization reaction of the polymerizable groups with each other between the acrylic polymers each having the structural units of polymerizable group-containing (meth)acrylate to cause the adhesive layer 22 to be cured. Thereby, it is possible to reduce the adhesive force of the adhesive layer 22 and, in the pick-up step, allow the die bonding sheet 10 to be easily peeled from the cured adhesive layer 22. Examples of the polymerization initiator that can be herein adopted include a photopolymerization initiator and a thermal polymerization initiator. As the photopolymerization initiator, a general product that is commercially-available can be used.

The adhesive layer 22 can further include additional components other than those described above. Examples of the additional components include a tackifier, a plasticizer, a filler, an aging retardant, an antioxidant, an ultraviolet absorber, a light stabilizer, a heat-resistant stabilizer, an antistat, a surfactant, and an easy-peeling agent. The type and amount of the additional components can be suitably selected depending on the purpose of use.

In this embodiment, it is preferable that the adhesive layer 22 include a component (e.g., the acrylic polymer having the structural units of the hydroxy group-containing (meth)acrylate, and the isocyanate compound) that causes a curing reaction by a curing treatment, and a gel fraction of the adhesive layer 22 after the curing treatment be 70% or more. The gel fraction of the adhesive layer 22 after the curing treatment being 70% or more causes the cohesion force inside the adhesive layer 22 to be further increased, to thereby more sufficiently suppress the phenomenon that, when the adhesive layer 22 is peeled from the die bonding sheet 10, part of the adhesive layer 22 is separated and adhered to a peeled surface of the die bonding sheet 10 in the vicinity of their interface. The aforementioned gel fraction can be 95% or less.

The aforementioned gel fraction is measured by the following method. Ultraviolet ray (e.g., 300 mJ/cm$^2$ ultraviolet ray) is irradiated to the adhesive layer 22 at such an energy amount to the extent that the adhesive layer 22 is sufficiently cured. A test piece of a square with a size of 5 cm × 5 cm is cut from the adhesive layer 22. The test piece is wrapped by a sheet made of polytetrafluoroethylene (PTFE) having a known mass. After the mass including the sheet (hereinafter, referred to as the total mass) is measured with a scale, the test piece is left in toluene at 23 °C for 7 days, followed by an extraction treatment to extract the sol in the test piece. Thereafter, a drying treatment at 120 °C for 2 hours is performed to measure the total mass with a scale after the drying treatment.

$$\text{Gel fraction (mass\%)} = 100 \times (\text{total mass after drying treatment - mass of}$$

$$\text{PTEF sheet}) \, / \, (\text{total mass before extraction treatment - mass of PTEF sheet})$$

The aforementioned gel fraction can be increased by reducing the content rate of the polar group-containing compound included in the adhesive layer 22, while the aforementioned gel fraction can be reduced by increasing the content rate of the polar group-containing compound included in the adhesive layer 22.

The dicing die bonding film 1 of this embodiment in a state before use can include a release liner that covers a surface on one side of the die bonding sheet 10 (i.e., a surface on which the die bonding sheet 10 is not laminated on the adhesive layer 22). The release liner is used for protecting the die bonding sheet 10 and peeled immediately before the adherend (e.g., semiconductor wafer W) is attached to the die bonding sheet 10. Examples of the release liner that can be used herein include a plastic film and paper subjected to the surface treatment by a remover such as a silicone-based remover, a long-chain alkyl-based remover, a fluorine-based remover, and molybdenum sulfide. The release liner can be used as a support material for supporting the die bonding sheet 10. The release liner is suitably used when the die bonding sheet 10 is laminated on the adhesive layer 22. Specifically, the die bonding sheet 10 can be laminated on the adhesive layer 22 by placing the die bonding sheet 10 with the release liner on the adhesive layer 22, followed by peeling (transferring) the release liner.

In the dicing die bonding film of this embodiment, the reduction of the peel force between the adhesive layer of the dicing tape and the die bonding sheet with time is suppressed and the peel force after the lapse of time is relatively high. Specifically, according to the dicing die bonding film 1 of this embodiment, since the die bonding sheet 10 and the adhesive layer 22 each include the polar group-containing compound, it is possible to suppress the transfer of the polar group-containing compound from the die bonding sheet 10 to the adhesive layer 22 in comparison with the case where only the die bonding sheet 10 includes the polar group-containing compound. It is assumed that this is because there is a small difference in the concentration of the polar group-containing compound included in each of the die bonding sheet 10 and the adhesive layer 22. While the transfer as described above occurs with the lapse of time, suppression of such a transfer enables to suppress the amount of the polar group-containing compound from increasing with time, the polar group-containing compound being capable of being present at the interface between the die bonding sheet 10 and the adhesive layer 22. When the polar group-containing compound is present at the aforementioned interface, the peel force between the die bonding sheet 10 and the adhesive layer 22 may be reduced. However, as described above, in the dicing die bonding film 1 of this embodiment, the polar group-containing compound is suppressed from being transferred with the lapse of time, and thus, it is possible to suppress the reduction of the peel force between the adhesive layer 22 of the dicing tape 20 and the die bonding sheet 10 with time. Further, since the peel force between the die bonding sheet 10 and the adhesive layer 22 is over 0.05 N/50 mm, the peel force can be maintained at a relatively high level even if the peel force is reduced with the lapse of time.

Subsequently, the description will be given on the method for producing the die bonding sheet 10 and the dicing die bonding film 1 of this embodiment.

<Method for producing a dicing die bonding film>

A method for producing the dicing die bonding film 1 of this embodiment includes a step of producing the die bonding sheet 10, a step of producing the dicing tape 20, a step of laminating the produced die bonding sheet 10 and the produced dicing tape 20 with each other.

(Step of producing the die bonding sheet)

The step of producing the die bonding sheet 10 includes a resin composition preparation step of preparing a resin composition for forming the die bonding sheet 10, and a die bonding sheet forming step of forming the die bonding sheet 10 from the resin composition.

In the resin composition preparation step, the resin composition is prepared by, for example, mixing the aforementioned crosslinkable acrylic resin and a solvent with any one of an epoxy resin, a curing catalyst of epoxy resin, and a phenol resin, to allow the resins to dissolve in a solvent. The viscosity of the composition can be adjusted by changing the amount of the solvent. As these resins, commercially-available products can be used.

In the die bonding sheet forming step, for example, the resin composition prepared as described above is applied to the release liner. The coating method is not particularly limited, and a general coating method such as roll coating, screen coating, or gravure coating can be adopted. Next, the applied composition is solidified by, for example, a desolvation treatment or a curing treatment, as necessary, to form the die bonding sheet 10.

(Step of producing the dicing tape)

The step of producing the dicing tape includes: a synthesizing step of synthesizing an acrylic polymer; an adhesive layer producing step of producing the adhesive layer 22 by causing the solvent to be volatilized from an adhesive composition including, as described above, the acrylic polymer, the isocyanate compound, the polymerization initiator, the solvent, and the additional component(s) appropriately added depending on the purpose; a base layer producing step of producing the base layer 21; and a lamination step of sticking the adhesive layer 22 and the base layer 21 to each other to allow the adhesive layer 22 and the base layer 21 to be laminated with each other.

In the synthesizing step, for example, a C7-C9 alkyl (meth)acrylate monomer having the hydrocarbon part with a carbon number of 7 or more and 9 or less and the hydroxy group-containing (meth)acrylic monomer are subjected to a radical polymerization, to synthesize an acrylic polymer intermediate. The radical polymerization can be made by a general method. For example, the acrylic polymer intermediate can be synthesized by dissolving the aforementioned monomers in the solvent and stirring them while heating, and thereafter adding the polymerization initiator to them. The polymerization can be performed in the presence of a chain transfer agent for adjustment of the molecular weight of the acrylic polymer. Next, the hydroxy group, which is part of the structural unit of the hydroxy group-containing (meth)acrylate included in the acrylic polymer intermediate, is bonded to the isocyanate group of the isocyanate group-containing polymerizable monomer by the urethanization reaction. Thereby, the part of the structural unit of the hydroxy group-containing (meth)acrylate is turned into the structural unit of the polymerizable group-containing (meth)acrylate. The urethanization reaction can be made by a general method. For example, the acrylic polymer intermediate and the isocyanate group-containing polymerizable monomer are stirred while being heated, in the presence of the solvent and a urethanization catalyst.

Thereby, the isocyanate group of the isocyanate group-containing polymerizable monomer can be bonded to part of the hydroxy group of the acrylic polymer intermediate by the urethane bonding.

In the adhesive layer producing step, for example, the acrylic polymer, the isocyanate compound, and the polymerization initiator are dissolved in the solvent to prepare the adhesive composition. The viscosity of the composition can be adjusted by changing the amount of the solvent. Next, the adhesive composition is applied to the release liner. As the coating method, a general coating method such as roll coating, screen coating, or gravure coating can be adopted. The applied composition is subjected to, for example, a desolvation treatment or a curing treatment, to cause the applied composition to be solidified to produce the adhesive layer 22.

In the base layer producing step, the base layer can be produced by forming a film by a general method. Examples of the method of forming a film include a calendaring method, a casting method in an organic solvent, an inflation extrusion method in a hermetically sealed system, a T-die extrusion method, and a dry lamination method. A co-extrusion forming method can be adopted. As the base layer 21, for example, a commercially-available film can be used.

In the lamination step, the adhesive layer 22 layered with the release liner is layered with the base layer to cause them to be laminated. The release liner can be in a state of being layered with the adhesive layer 22 until it is used. After the lamination step, an aging treatment step can be additionally performed in the environment at 50 °C for 48 hours in order to accelerate the reaction of the isocyanate compound (i.e., crosslinking agent) with the acrylic polymer, and, in order to accelerate the reaction of isocyanate compound (i.e., crosslinking agent) with a surface part of the base layer 21.

The dicing tape 20 can be produced by these steps.

(Step of layering the die bonding sheet 10 with the dicing tape 20)

In the step of layering the die bonding sheet 10 with the dicing tape 20, the die bonding sheet 10 is stuck to the adhesive layer 22 of the dicing tape 20 produced in the manner as described above.

In the sticking, the release liner is peeled from each of the adhesive layer 22 of the dicing tape 20 and the die bonding sheet 10, and the die bonding sheet 10 and the adhesive layer 22 are stuck to each other so that both of them come into direct contact with each other. For example, both can be stuck to each other by pressure bonding. The temperature when both are stuck to each other is not particularly limited, and is, for example, 30 °C or more and 50 °C or less. The linear pressure when both are stuck to each other is not particularly limited, and is preferably 0.1 kgf/cm or more and 20 kgf/cm or less. Before or after both are stuck to each other, the adhesive layer 22 can be cured by irradiating the adhesive layer 22 of the dicing tape 20 with ultraviolet ray or the like. This enables to appropriately reduce the adhesive force of the adhesive layer 22 to improve the storage stability of the adhesive layer 22, and accordingly enables a better pick-up performance when a semiconductor chip is picked up. In the case where, after both are stuck to each other, the adhesive layer 22 is cured by irradiation of ultraviolet ray or the like, the adhesive layer 22 can be cured by irradiation of ultraviolet ray or the like, for example, before the pick-up step (to be describe later) during the process of producing a semiconductor device using the dicing die bonding film 1.

The semiconductor device produced herein is used for the purpose of, for example, power control such as those for a rectifier diode and a power transistor. The semiconductor device used for such a purpose includes a semiconductor chip having a thickness of, for example, 10 $\mu$m or more and 500 $\mu$m or less, and a die bonding sheet having a thickness of, for example, 1 $\mu$m or more and 100 $\mu$m or less.

After being subjected to the aforementioned steps, the dicing die bonding film 1 produced in the manner as described above is used as, for example, an assisting device in producing a semiconductor device (i.e., semiconductor integrated circuit). Hereinafter, illustrative embodiments of the usage of the dicing die bonding film 1 will be described.

<Usage of the dicing die bonding film in the production of a semiconductor device>

In general, a method of producing a semiconductor device includes a step of cutting a chip from a semiconductor wafer having a circuit side formed thereon, followed by assembling. This step includes, for example: a mounting step of sticking a surface on one side of the semiconductor wafer (e.g., surface on the opposite side to the circuit side) to the die bonding sheet 10 to fix the semiconductor wafer to the dicing tape 20; a dicing step of cutting the semiconductor wafer and the die bonding sheet 10 into small pieces; an expanding step (performed as necessary) of stretching the dicing tape 20 to thereby expand the gap between each adjacent chips of the semiconductor wafer cut into small pieces; a pick-up step of peeling the die bonding sheet 10 from the adhesive layer 22 to pick up the semiconductor chip (i.e., die) with the die bonding sheet 10 stuck thereto; a die bonding step of bonding the die bonding sheet 10 stuck to the semiconductor chip (i.e., die) to an adherend; a curing step of curing the die bonding sheet 10 bonded to the adhered; a wire bonding step of electrically connecting an electrode of a circuit on the semiconductor chip (i.e., die) with the adherend by a wire; and a sealing step of sealing the semiconductor chip (i.e., die) and the wire on the adherend by a thermosetting resin. During the performance of these steps, the dicing tape (i.e., dicing die bonding film) of this embodiment is used as an assisting device in production.

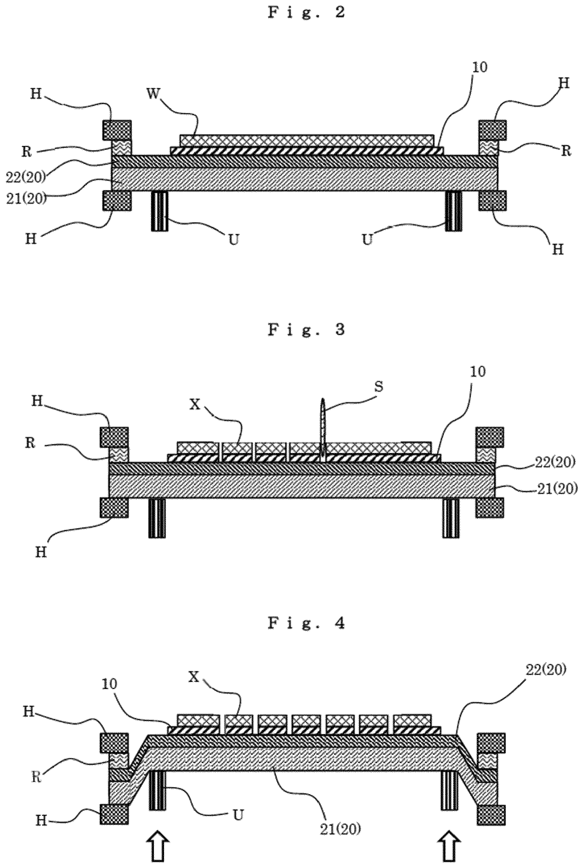

In the mounting step, as shown in Fig. 2, the semiconductor wafer W is fixed to the dicing tape 20. Specifically, the semiconductor wafer W is stuck to a surface on which the die bonding sheet 10 is exposed, while mounting a dicing ring R to the adhesive layer 22 of the dicing tape 20.

In the dicing step, as shown in, for example, Fig. 3, the die bonding sheet 10 and the semiconductor wafer W are cut into small pieces by a dicing saw S or the like, to produce small pieces of the die bonding sheet 10 and the semiconductor wafer W on the dicing tape 20.

In the expanding step performed as necessary, as shown in Fig. 4, the gap between each adjacent semiconductor chips (i.e., dies) X produced by the semiconductor wafer W cut into small pieces is expanded. Specifically, a thrusting-up member U provided in an expander is thrusted up from the lower side of the dicing die bonding film 1 so that the dicing die bonding film 1 is stretched to extend in the plane direction. Thereby, each adjacent semiconductor chips X are separated from each other in the plane direction of the film surface to expand the kerf (i.e., gap) therebetween.

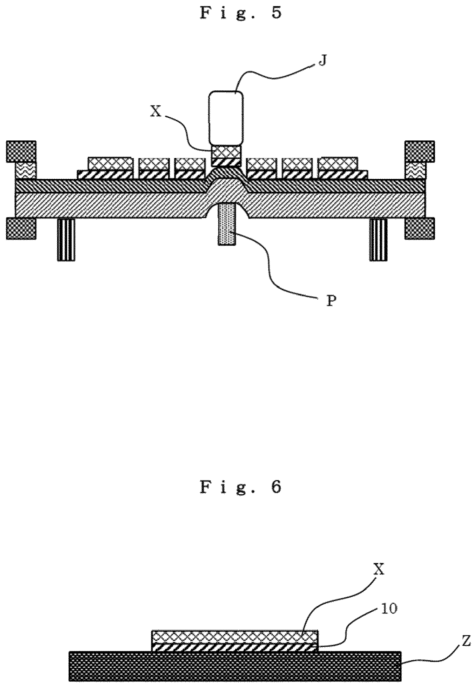

In the pick-up step, as shown in Fig. 5, the semiconductor chip X with the die bonding sheet 10 stuck thereto is peeled from the adhesive layer 22 of the dicing tape 20. Specifically, a pin member P is raised to thrust up the semiconductor chip X as a pick-up object via the dicing tape 20. The semiconductor chip X that has been thrust up is held by a sucking tool J.

In the die bonding step, as shown in Fig. 6, the semiconductor chip X with each small piece of the die bonding sheet 10 stuck thereto is bonded to the adherend Z.

In the curing step, a heating treatment is performed at a temperature of, for example, 80 °C or more and 255 °C or less in order to enhance the reaction activity of the crosslinkable group (e.g., epoxy group) in the thermosetting resin included in the die bonding sheet 10 to thereby proceed the curing of the die bonding sheet 10.

In the wire bonding step, the semiconductor chip X (i.e., die) and the adherend Z are connected by a wire, while being heated.

In the sealing step, the semiconductor chip X (i.e., die) and the die bonding sheet 10 are sealed with the thermosetting resin such as an epoxy resin. In the sealing step, the heating treatment is performed at a temperature of, for example, 150 °C or more and 200 °C or less in order to proceed the curing reaction of the thermosetting resin M.

The dicing die bonding film of this embodiment is as exemplified above, but is not limited to the exemplified dicing die bonding film at all. That is, various forms used in general dicing die bonding films can be adopted without deteriorating the effect of the present invention.

The matters disclosed herein include the following.

(1) A dicing die bonding film including a dicing tape including a base layer, an adhesive layer laminated on the base layer, and a die bonding sheet laminated on the adhesive layer of the dicing tape, in which

the die bonding sheet includes conductive metal particles,
the die bonding sheet and the adhesive layer each include a polar group-containing compound,
the polar group-containing compound is a compound having at least one of one or more hydroxy groups or a plurality of ether bonds in a molecule, and
a peel force between the die bonding sheet and the adhesive layer is more than 0.05 N/50 mm.

(2) The dicing die bonding film according to the above (1), in which

the adhesive layer includes an acrylic polymer having structural units of alkyl (meth)acrylate in the molecule, and
a ratio of the structural units of alkyl (meth)acrylate in which a carbon number of an alkyl part is 8 or more is highest among the structural units of the acryl polymer in the molecule.

(3) The dicing die bonding film according to the above (1) or (2), in which

the adhesive layer includes a component that causes a curing reaction by a curing treatment, and
a gel fraction of the adhesive layer after the curing treatment is 70% or more.

(4) The dicing die bonding film according to any one of the above (1) to (3), in which
Y/X is more than 0.5 and less than 1.5 where the peel force is X and a peel force after the lapse of 7 days from measurement of the peel force X is Y.

(5) The dicing die bonding film according to any one of the above (1) to (4), in which
a formula below is satisfied, where a ratio of the polar group-containing compound in a mass of the adhesive layer is A (mass%) and a ratio of the polar group-containing compound to the total mass of a resin component and the polar group-containing compound included in the die bonding sheet is B (mass%),

$$0.1 \leq A/B \leq 3.0.$$

(6) The dicing die bonding film according to the above (5), in which
the above formula satisfies a formula below,

$$0.5 \leq A/B \leq 2.0.$$

(7) The dicing die bonding film according to any one of the above (1) to (6), in which

a vapor pressure of the polar group-containing compound at 25 °C is 1 mmHg or less, and
a glass transition point of the polar group-containing compound is 250 °C or less.

(8) The dicing die bonding film according to any one of the above (1) to (7), in which
the polar group-containing compound is a compound that has a molecule structure in which one carbon in a C6
saturated cyclic hydrocarbon is covalently bonded to one carbon in a C7 saturated cyclic hydrocarbon having two
saturated cyclic hydrocarbons sharing two carbons, and one hydroxy group is included in the molecule.
(9) The dicing die bonding film according to any one of the above (1) to (8), in which
the die bonding sheet includes 85 mass% or more and 97 mass% or less of the conductive metal particles.
(10) The dicing die bonding film according to any one of the above (1) to (9), in which
the conductive metal particles include at least one selected from the group consisting of silver, copper, silver oxide,
and copper oxide.
(11) The dicing die bonding film according to any one of the above (1) to (10), in which 0.1 mass% or more and 10.0
mass% or less of the polar group-containing compound is included.
(12) The dicing die bonding film according to any one of the above (1) to (11), in which
the die bonding sheet includes a thermosetting resin.
(13) The dicing die bonding film according to the above (12), in which
the die bonding sheet includes an epoxy resin as the thermosetting resin.
(14) The dicing die bonding film according to any one of the above (1) to (13), in which
the die bonding sheet includes an acrylic resin.
(15) The dicing die bonding film according to the above (14), in which
the acrylic resin is a copolymer of alkyl (meth)acrylate and at least one crosslinkable group-containing monomer
selected from a carboxy group-containing (meth)acrylic monomer and a hydroxy group-containing (meth)acrylic
monomer.
(16) The dicing die bonding film according to any one of the above (1) to (15), in which

the adhesive layer includes an acrylic polymer having at least structural units of alkyl (meth)acrylate in the
molecule, and
the acrylic polymer includes, in the molecule, at least a structural unit of alkyl (meth)acrylate in which a branched
alkyl part has a carbon number of 8 or more, a structural unit of hydroxy group-containing (meth)acrylate, a
structural unit of polymerizable group-containing (meth)acrylate, and a structural unit of (meth)acrylate having
a heterocycle (hetero ring) structure.

EXAMPLES

Hereinafter, the present invention will be described in more detail by way of examples of experiment, but the
following examples are provided for more detailed explanation of the present invention, and do not intend to limit the
scope of the present invention.
A dicing tape and a die bonding sheet were produced in the following manner. Also, a dicing die bonding film
was produced by sticking the produced dicing tape and the produced die bonding sheet to each other.

<Production of each dicing tape>

(Base layer)

A base layer (total thickness: 100 μm) with three layers laminated together was produced using products referred
below as raw materials.

• Resin for forming an inner layer

Material name: ULTRASEN 751, ethylene-vinyl acetate copolymer (EVA containing 28 mass% of vinyl acetate) manufactured by Tosoh Corporation

• Resin for forming an outer layer

Material name: WINTEC WF X4M, metallocene polypropylene manufactured by Japan Polypropylene Corporation

(Molding of the base layer)

The base layer was molded using an extrusion T-die molding machine. The temperature for extrusion was 190 °C. The three layers were integrated by co-extrusion from a T-die when these layers were laminated together. After the integrated base layer (i.e., laminate body) was sufficiently solidified, the base layer was wound in a rolled shape and stored.

(Adhesive layer)

The raw materials (i.e., a monomer, a polymerization initiator, and the like) were respectively put into a reaction vessel equipped with a cooling pipe, a nitrogen introduction pipe, a thermometer, and a stirring device to have polymer compositions shown in Table 1. Polymerization treatment was performed in a nitrogen flow at 61°C for 6 hours to obtain each of a plurality of different acrylic polymers A. The details of the materials provided in abbreviation in Table 1 are as follows:

- LMA: lauryl methacrylate
- 2-EHA: 2-ethylhexyl acrylate
- ACMO: acryloylmorpholine
- HEA: 2-hydroxyethyl acrylate
- HEMA: 2-hydroxyethyl methacrylate
- BPO: benzoyl peroxide (polymerization initiator)
- MOI: 2-methacryloyloxyethyl isocyanate (added after the polymerization treatment)

The aforementioned MOI was added in the amount as shown in Table 1 to a liquid including the acrylic polymer A obtained by the polymerization treatment. Then, an addition reaction treatment was performed in an air flow at 50 °C for 48 hours, to obtain each of acrylic polymers A'. The obtained acrylic polymers A' are respectively referred to as A'-1, A'-2, A'-3, and A'-4. Next, the following components were added in the amounts as respectively shown in Table 2 and Table 3, based on 100 parts by mass (in terms of solids content) of the acrylic polymer A', to prepare an adhesive solution.

- Polar group-containing compound (isobornyl cyclohexanol): blending amount as shown in Table 2 and Table 3 (product name: "Terusolve MTPH" manufactured by NIPPON TERPENE CHEMICALS, INC.) described as MTPH
- Polyisocyanate compound: 0.75 parts by mass (product name: "Takenate D-101A" manufactured by Mitsui Chemicals, Inc.)
- Photopolymerization initiator: 2 parts by mass (product name: "Omnirad 651" manufactured by IGM Resins B.V.)

The adhesive solution prepared as described above was applied on a treatment surface of a PET release liner subjected to a silicone treatment, followed by crosslinking at 120 °C for 2 minutes, to form an adhesive layer having a thickness of 30 μm. Subsequently, one surface of the formed adhesive layer was stuck to one surface of the laminated base layer (i.e., the surface facing inside), and held at 50 °C for 24 hours. Further, using an ultraviolet ray irradiator (product name: "UM810" manufactured by NITTO SEIKI CO., Ltd.), 300 mJ/cm$^2$ ultraviolet ray was irradiated from the laminated base layer side to only an area to which the semiconductor wafer is mounted, to thereby sufficiently cure the adhesive layer. A dicing tape was produced in this way.

Table 1

| | Unit: parts by mass (molar ratio in parentheses) | | | |
|---|---|---|---|---|
| | Acrylic polymer A' (blended in adhesive layer) | | | |
| Composition (monomer, etc.) | A'-1 | A'-2 | A'-3 | A'-4 |
| LMA | - | - | 100.00 (100) | - |
| 2-EHA | 100.00 (100) | 100.00 (63) | - | 100.00 (75) |
| ACMO | - | 20.7 (17) | - | 25.5 (25) |
| HEA | 12.6 (20) | 20.0 (20) | - | 18.5 (22) |
| HEMA | - | - | 10.2 (20) | - |
| BPO | 0.3 (0.2) | 0.4 (0.2) | 0.2 (0.2) | 0.4 (0.2) |
| MOI | 13.5 (16) | 9.8 (16) | 21.4 (16) | 22.5 (20) |
| Toluene (solvent) | 7.3 | 7.2 | 9.1 | 9.4 |

<Production of a die bonding sheet>

In each of Examples and Comparative Examples, a die bonding sheet produced as below was used. A mixture of materials at the respective amounts below was stirred for 3 minutes using a hybrid mixer (product name: "HM-500" manufactured by KEYENCE CORPORATION) to prepare a varnish. The varnish was applied to one surface of a release treatment film (product name: "MRA38", with a thickness of 38 $\mu$m, manufactured by Mitsubishi Chemical Corporation). Then, a drying treatment at a temperature of 100 °C for 2 minutes was performed to produce a die bonding sheet having a thickness of 30 $\mu$m. The thermal conductivity of the produced die bonding sheet was 20 (W/m·K). The details and the blending amounts of the materials used herein are as follows. The ratio of the polar group-containing compound to the total amount of the phenol resin, the epoxy resin, the acrylic resin, and the polar group-containing compound (the silane coupling agent and the catalyst is not included in the total amount) was 20 mass%.

- Phenol resin: 144.6 parts by mass (biphenyl aralkyl type phenol resin, hydroxy group equivalent of 209 g/eq); product name: "MEHC-7851A" manufactured by MEIWA PLASTIC INDUSTRIES, LTD.
- Solid epoxy resin: 94.3 parts by mass (cresol novolak type multifunctional epoxy resin, epoxy equivalent of 200 g/eq); product name: "EPICLON N-665-EXP-S" manufactured by DIC Corporation
- Liquid epoxy resin: 40.4 parts by mass (bisphenol A type epoxy resin, epoxy equivalent of 180 g/eq); product name: "jER YL980" manufactured by Mitsubishi Chemical Corporation
- Conductive metal particles: 3160.6 parts by mass of silver (Ag)-coated copper (Cu) particles; product name: "AOP-TCY-2(EN)" manufactured by DOWA Electronics Materials Co., Ltd.
- Conductive metal particles: 7374.8 parts by mass of silver (Ag) particles; product name: "AG-2-8F" manufactured by DOWA Electronics Materials Co., Ltd.
- Polar group-containing compound: 139.3 parts by mass of isobornyl cyclohexanol; product name: "Terusolve MTPH" manufactured by NIPPON TERPENE CHEMICALS, INC.)
- Acrylic resin solution: 2236.6 parts by mass (solid content: 279.6 parts by mass); product name: "TEISANRESIN SG-70L" manufactured by Nagase ChemteX Corporation (MEK and toluene are included as a solvent, a solid content: 12.5 parts by mass, a glass transition temperature: -13 °C, a mass average molecular weight: 900,000, and an acid number: 5 mg/KOH, a carboxy group-containing acrylic copolymer)
- Silane coupling agent (alkoxysilane compound): 21.3 parts by mass; 2-triethoxysilylpropyl disulfidesilane; product name: "XIAMETER OFS-6920" manufactured by The Dow Chemical Company
- Catalyst: 1.6 parts by mass; tetraphenylphosphonium tetra-p-tolylborate; product name: "TPP-MK" manufactured by HOKKO CHEMICAL INDUSTRY CO., LTD.
- Solvent: 1644.2 parts by mass; methyl ethyl ketone (MEK)

<Production of the dicing die bonding film>

(EXAMPLES 1 to 5)

The die bonding sheet produced as described above was stuck, using a hand roller, to the adhesive layer of the dicing tape having an adhesive layer made of the mixture of the blending components of each of the blending compositions shown in Table 2 or Table 3 below to produce each of the dicing die bonding films.

(Comparative Examples 1, 2)

The die bonding sheet produced as described above was stuck, using a hand roller, to the adhesive layer of the dicing tape having an adhesive layer made of the mixture of the blending components of each of the blending compositions shown in Table 2 or Table 3 below to produce each of the dicing die bonding films.

The composition and the physical characteristics of the adhesive layer in each of Examples and Comparative Examples are shown in Table 2 and Table 3.

Table 2

| | C. Ex. 1 | | Ex. 1 | | Ex. 2 | | Ex. 3 | |
|---|---|---|---|---|---|---|---|---|
| Blending amount in adhesive layer | parts by mass | mass% | parts by mass | mass% | parts by mass | mass% | parts by mass | mass% |
| A'-1 (acrylic polymer A') | 100 | : 97.3% | 100 | 91.2% | 100 | : 81.0% | 100 | 72.9% |
| MTPH | - | - | 6.88 | 6.3% | 20.64 | : 16.7% | 34.40 | 25.1% |
| Omnirad651 | 2.0 | 1.9% | 2.0 | 1.8% | 2.0 | 1.6% | 2.0 | 1.5% |
| TAKENATE D-101A | 0.75 | 0.7% | 0.75 | 0.7% | 0.75 | 0.6% | 0.75 | 0.5% |
| # (cf. Formula (1) below) | 0 | | 0.32 | | 0.84 | | 1.26 | |
| Gel fraction of adhesive layer | 100% | | 93% | | 85% | | 75% | |
| Peel force between adhesive layer and die bonding sheet | | | | | | | | |
| Peel force X | 0.15 [N/50 mm] | | 0.10 [N/50 mm] | | 0.12 [N/50 mm] | | 0.08 [N/50 mm] | |
| Peel force Y after lapse of time | 0.05 [N/50 mm] | | 0.06 [N/50 mm] | | 0.10 [N/50 mm] | | 0.07 [N/50 mm] | |
| Y/X | 0.33 | | 0.60 | | 0.83 | | 0.88 | |

Table 3

| | Ex. 4 | | C. Ex. 2 | | Ex. 5 | |
|---|---|---|---|---|---|---|
| Blending amount in adhesive layer | parts by mass | mass% | parts by mass | mass% | parts by mass | mass% |
| A'-1 (acrylic polymer A') | - | - | - | - | - | - |
| A'-2 (acrylic polymer A') | 100 | 81.0% | - | - | - | - |
| A'-3 (acrylic polymer A') | - | - | 100 | 81.0% | - | - |
| A'-4 (acrylic polymer A') | - | - | - | - | 100 | 81.0% |
| MTPH | 20.64 | 16.7% | 20.64 | 16.7% | 20.64 | 16.7% |
| Omnirad651 | 2.00 | 1.6% | 2.00 | 1.6% | 2.00 | 1.6% |
| TAKENATE D-101A | 0.75 | 0.6% | 0.75 | 0.6% | 0.75 | 0.6% |
| # (cf. Formula (1) below) | 0.84 | | 0.84 | | 0.84 | |
| Gel fraction of adhesive layer | 85 % | | 85 % | | 85 % | |
| Peel force between adhesive layer and die bonding sheet | | | | | | |
| Peel force X | 0.18 [ N/50 mm] | | 0.05 [ N/50 mm] | | 0.21 [ N/50 mm] | |

(continued)

| Peel force between adhesive layer and die bonding sheet | | | |
|---|---|---|---|
| Peel force Y after lapse of time | 0.17 [ N/50 mm] | 0.02 [ N/50 mm] | 0.22 [ N/50 mm] |
| Y/X | 0.94 | 0.40 | 1.05 |

Formula 1

\# = Content rate A (mass%) of the polar group-containing compound in the adhesive layer / Ratio B (mass%) of polar group-containing compound to the total amount of the resin components and the polar group-containing compound in the die bonding sheet.

<Gel fraction of the adhesive layer of the dicing tape>

A gel fraction of the adhesive layer was obtained by the aforementioned method. The curing treatment was performed by irradiation of 300 mJ/cm$^2$ ultraviolet ray as described above.
Evaluations were made in the manner as described below for the performance of each of the dicing die bonding films produced as described above.

<Peel force between the adhesive layer and the die bonding sheet>

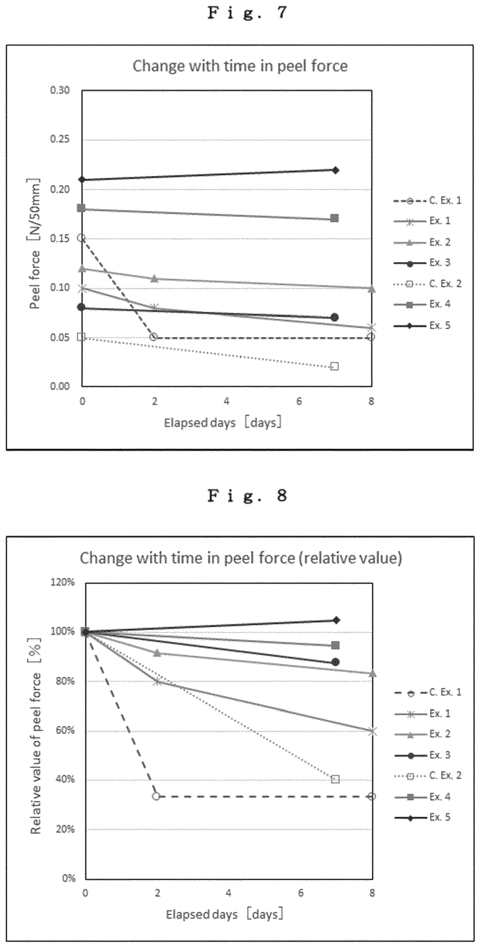

The peel force between the adhesive layer and the die bonding sheet was measured by the aforementioned method. As the peel force, a peel force X (i.e., initial peel force) immediately after the production of each of the dicing die bonding film and a peel force Y after the lapse of 7 days or 8 days (as necessary, after the lapse of 2 days) at room temperature from the measurement of the initial peel force were measured. The measurement results are shown in Table 2 and Table 3. The results of measurement of the peel force made into a graph are shown in Fig. 7 and Fig. 8.
As seen from the above evaluation results, in the dicing die bonding film of each of Examples, the die bonding sheet and the adhesive layer each include a polar group-containing compound, the polar group-containing compound is a compound having at least one of one or more hydroxy groups or a plurality of ether bonds in a molecule, and a peel force between the die bonding sheet and the adhesive layer is more than 0.05 N/50 mm. With this configuration, the dicing die bonding films of Examples can suppress the peel force between the adhesive layer of the dicing tape and the die bonding sheet from being reduced with time and can have the aforementioned peel force being relatively high after the lapse of time, compared with the dicing die bonding films of Comparative Examples.
The use of these dicing die bonding films of Examples in the production of the semiconductor device can suppress, for example, a phenomenon (i.e., the so-called chip-flying phenomenon) that, when the semiconductor wafer and the die bonding sheet each are cut into small pieces in the dicing step described above, the small pieces of the die bonding sheet and the semiconductor chip are unintentionally peeled from the adhesive layer. In order to suppress such a phenomenon, the die bonding sheet and the adhesive layer in the dicing die bonding film of each of Examples includes the polar group-containing compound as specified above, and the peel force between the die bonding sheet and the adhesive layer is more than 0.05 N/50 mm.
Meanwhile, an investigation was conducted in the following manner to confirm whether or not the transfer of the polar group-containing compound (specifically, isobornyl cyclohexanol) with time occurs in the dicing die bonding film in which the die bonding sheet including the polar group-containing compound and the adhesive layer without including polar group-containing compound are layered with each other. Specifically, it was confirmed that (by, for example, thermogravimetric (TG) analysis), after the lapse of 2.5 months from the production of the dicing die bonding film, isobornyl cyclohexanol was present inside the adhesive layer and the amount of isobornyl cyclohexanol contained in the die bonding sheet was reduced compared with the amount at the time of the production of the dicing die bonding film. As is evident from the above, it can be said that the phenomenon of the transfer of the polar group-containing compound from the die bonding sheet to the adhesive layer occurs with the lapse of time. The thermogravimetric analysis was performed for the die bonding sheet immediately after the production and the die bonding sheet after the lapse of 2.5 months from the production under an inert gas (e.g., nitrogen gas) atmosphere at a heating rate of 10 °C/min. As a result, the rate of change in thermal weight around 100 °C to 200 °C was greater in the latter die bonding sheet than in the former die bonding sheet. The component analysis of a gas generated around the aforementioned temperature confirms that the gas includes isobornyl cyclohexanol.

Industrial applicability

The dicing die bonding film of the present invention can be preferably used as, for example, an assisting device in the production of the semiconductor device.

REFERENCE SIGNS LIST

1: Dicing die bonding film
10: Die bonding sheet
20: Dicing tape
21: Base layer
22: Adhesive layer

**Claims**

1. A dicing die bonding film comprising a dicing tape including a base layer, an adhesive layer laminated on the base layer, and a die bonding sheet laminated on the adhesive layer of the dicing tape, wherein

    the die bonding sheet comprises conductive metal particles,
    the die bonding sheet and the adhesive layer each comprise a polar group-containing compound,
    the polar group-containing compound is a compound having at least one of one or more hydroxy groups or a plurality of ether bonds in a molecule, and
    a peel force between the die bonding sheet and the adhesive layer is more than 0.05 N/50 mm.

2. The dicing die bonding film according to claim 1, wherein

    the adhesive layer comprises an acrylic polymer having at least structural units of alkyl (meth)acrylate in the molecule, and
    a ratio of the structural units of alkyl (meth)acrylate in which a carbon number of an alkyl part is 8 or more is highest among the structural units of the acryl polymer in the molecule.

3. The dicing die bonding film according to claim 1 or 2, wherein

    the adhesive layer comprises a component that causes a curing reaction by a curing treatment, and
    a gel fraction of the adhesive layer after the curing treatment is 70% or more.

4. The dicing die bonding film according to any one of claims 1 to 3, wherein
    Y/X is more than 0.5 and less than 1.5 where the peel force is X and a peel force after the lapse of 7 days from measurement of the peel force X is Y.

5. The dicing die bonding film according to any one of claims 1 to 4, wherein
    a formula below is satisfied, where a ratio of the polar group-containing compound in a mass of the adhesive layer is A (mass%) and a ratio of the polar group-containing compound to the total mass of a resin component and the polar group-containing compound included in the die bonding sheet is B (mass%),

$$0.1 \leq A/B \leq 3.0.$$

6. The dicing die bonding film according to any one of claims 1 to 5, wherein

    a vapor pressure of the polar group-containing compound at 25 °C is 1 mmHg or less, and
    a boiling point of the polar group-containing compound is 200 °C or more and 350 °C or less.

**7.** The dicing die bonding film according to any one of claims 1 to 6, wherein
the die bonding sheet comprises 85 mass% or more and 97 mass% or less of the conductive metal particles.

**8.** The dicing die bonding film according to any one of claims 1 to 7, wherein
the conductive metal particles comprise at least one selected from the group consisting of silver, copper, silver oxide, and copper oxide.

**9.** The dicing die bonding film according to any one of claims 1 to 8, wherein
the die bonding sheet comprises a thermosetting resin.

**10.** The dicing die bonding film according to claim 9, wherein
the die bonding sheet comprises an epoxy resin as the thermosetting resin.

**11.** The dicing die bonding film according to any one of claims 1 to 10, wherein
the die bonding sheet comprises an acrylic resin.

Fig. 1

Fig. 2

Fig. 3

Fig. 4

F i g . 5

F i g . 6

Fig. 7

Fig. 8

Europäisches
Patentamt

European
Patent Office

Office européen
des brevets

**EUROPEAN SEARCH REPORT**

Application Number

EP 22 20 7886

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | EP 3 929 258 A1 (NITTO DENKO CORP [JP]) 29 December 2021 (2021-12-29) * paragraphs [0001] – [0014], [0037], [0055] – [0073]; claims 1-7 * * paragraphs [0115] – [0122]; tables 1,2 * ----- | 1-11 | INV. C09J7/30 B32B7/12 H01L21/683 |
| X | EP 3 819 349 A1 (NITTO DENKO CORP [JP]) 12 May 2021 (2021-05-12) * paragraphs [0001] – [0012]; claims 1-6 * * paragraphs [0041] – [0066] * ----- | 1-11 | |

TECHNICAL FIELDS SEARCHED (IPC)

C09J
B32B
C08K
H01L

The present search report has been drawn up for all claims

| Place of search | Date of completion of the search | Examiner |
|---|---|---|
| Munich | 16 March 2023 | Alevizopoulou, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 .....................................................................

& : member of the same patent family, corresponding document

EPO FORM 1503 03.82 (P04C01)

**EP 4 183 848 A1**

## ANNEX TO THE EUROPEAN SEARCH REPORT
## ON EUROPEAN PATENT APPLICATION NO.

EP 22 20 7886

This annex lists the patent family members relating to the patent documents cited in the above-mentioned European search report.
The members are as contained in the European Patent Office EDP file on
The European Patent Office is in no way liable for these particulars which are merely given for the purpose of information.

16-03-2023

| Patent document cited in search report | | Publication date | Patent family member(s) | | Publication date |
|---|---|---|---|---|---|
| EP 3929258 | A1 | 29-12-2021 | CN | 113831865 A | 24-12-2021 |
| | | | EP | 3929258 A1 | 29-12-2021 |
| | | | TW | 202208585 A | 01-03-2022 |
| | | | US | 2021403784 A1 | 30-12-2021 |
| EP 3819349 | A1 | 12-05-2021 | CN | 112778694 A | 11-05-2021 |
| | | | EP | 3819349 A1 | 12-05-2021 |
| | | | JP | 7210421 B2 | 23-01-2023 |
| | | | JP | 2021077765 A | 20-05-2021 |
| | | | TW | 202128874 A | 01-08-2021 |
| | | | US | 2021139745 A1 | 13-05-2021 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021077765 A